# EUROPÄISCHE PATENTSCHRIFT

(11) **EP 0 720 787 B1**
(45) Veröffentlichungstag und Bekanntmachung des Hinweises auf die Patenterteilung: **02.05.1997**
(21) Anmeldenummer: 94928379.0
(22) Anmeldetag: 19.09.1994
(51) Int. Cl.: H02M 7/00

(54) **UMFORMER**
CONVERTER
CONVERTISSEUR

(30) Priorität: 22.09.1993 DE 9314286 U
(43) Veröffentlichungstag der Anmeldung: 10.07.1996
(73) Patentinhaber: HONEYWELL AG, 63067 Offenbach (DE)
(72) Erfinder: BUG, Bernhard, D-36124 Eichenzell (DE); FIEBIG, Günter, D-63584 Gründau 3 (DE)
(74) Vertreter: Herzbach, Dieter, Dipl.-Ing.
(86) Internationale Anmeldenummer: EP9403135
(87) Internationale Veröffentlichungsnummer: WO9508864

(56) Entgegenhaltungen:
- DE-A- 4 020 026
- US-A- 5 172 310
- EPE '93 FIFTH EUROPEAN CONFERENCE ON POWER ELECTRONICS AND APPLICATIONS, Bd.6, 13. September 1993, BRIGHTON Seiten 92 - 96, XP416848 SCHÜTZE 'Low floor trams with IGBT 3-level inverter'

## Beschreibung

Die vorliegende Erfindung betrifft einen modular aufgebauten elektrischen Umformer nach dem Gattungsbegriff des Patentanspruches 1.

Aus der EP-A-0 455 120 ist beispielsweise eine Stromrichteranlage mit Gleichspannungszwischenkreis bekannt, bei der ein Stromschienensystem benutzt wird, um eine Kondensatorbatterie und Stromrichtermodule anzuschließen, so daß sich ein modularer Aufbau für einen Wechselrichter ergibt.

Aufgabe der vorliegenden Erfindung ist es, einen Umformer gemäß dem stand der weiterzubilden Technik, der alle erforderlichen Komponenten in einem sehr kompakten Modul vereinigt.

Die Lösung dieser Aufgabe gelingt gemäß den kennzeichnenden Merkmalen des Patentanspruches 1. Weitere vorteilhafte Ausgestaltungen des Umformermoduls sind den abhängigen Ansprüchen entnehmbar.

Anhand eines in den Figuren der beiliegenden Zeichnung dargestellten Ausführungsbeispieles sei im folgenden der Umformer näher beschrieben. Es zeigen:
- Figur 1: eine Draufsicht auf den Umformer bei aufgeschnittener Haube;
- Figur 2: eine Vorderansicht des Umformers bei entfernter Vorderwand;
- Figur 2a: eine Einzelheit aus Fig. 2 in vergrößerter Darstellung; und
- Figur 3: eine Seitenansicht des Umformers bei auf getrennter Seitenwand.

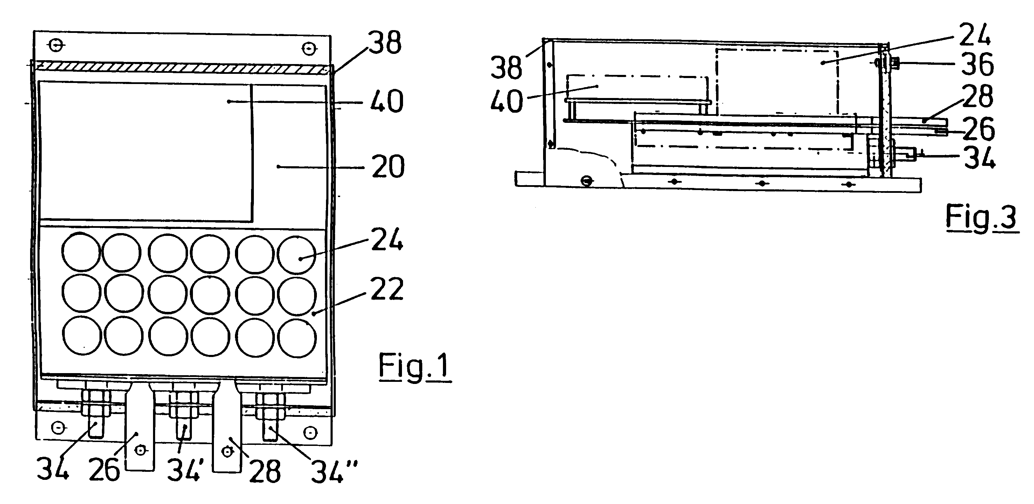

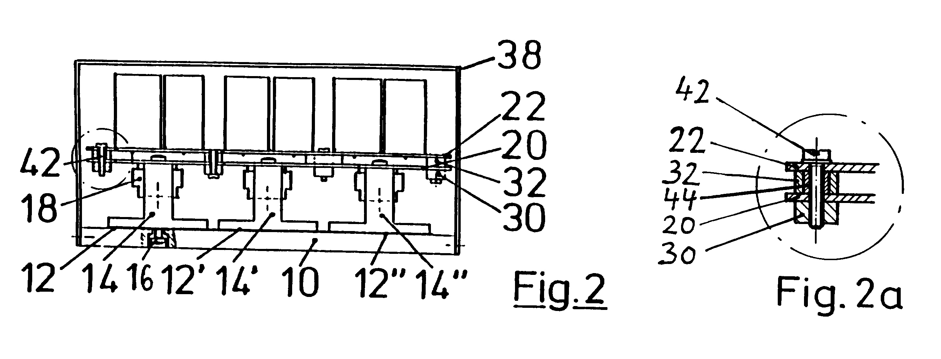

Gemäß den Figuren 1 bis 3 sitzen auf einer massiven rechteckigen metallischen Grundplatte 10 unter Zwischenfügung von elektrisch isolierenden, aber relativ gut wärmeleitenden Schichten 12, 12', 12" drei T-förmige Stromschienen 14, 14' und 14". Die Befestigung der Stromschienen kann über Schrauben 16 erfolgen. Die Stromschienen 14, 14' und 14" sitzen mit ihrem Quersteg unter Zwischenfügung der Isolierschichten 12, 12' und 12" auf der metallischen Grundplatte 10. An den Längsstegen der Stromschienen 14, 14' und 14" sind Feldeffekttransistoren 18 angeordnet. Auf den freien Enden der Längsstege der Stromschienen 14, 14' und 14" stützt sich eine Leistungsplatine 20 ab. Im Abstand über der Leistungsplatine 20 befindet sich eine Kondensatorplatine 22, auf der aufrecht die Kondensatoren einer Kondensatorbatterie 24 sitzen.

Eine erste Metallfahne 26 dient der Zuführung der positiven Spannung und eine zweite Metallfahne 28 dient der Zuführung der negativen Spannung. Eine erste metallische Schiene 30 auf der Unterseite der Leistungsplatine 20 führt das positive Potential. Eine zwischen der Leistungsplatine 20 und der Kondensatorplatine 22 angeordnete zweite metallische Schiene 32 führt das negative Potential und hält gleichzeitig beide Platinen 20, 22 im Abstand. Eine Ansteuerelektronik 40 ist seitlich von der Kondensatorbatterie 24 angeordnet und mit der Leistungsplatine 20 verbunden.

Die aus der Leistungsplatine 20, der Kondensatorplatine 22 und den beiden metallischen Schienen 30, 32 bestehende Anordnung ist über Schrauben 42 zusammengehalten, wobei die Schrauben 42 durch die Platinen und mittels einer Isolierhülse 44 durch die innenliegende Schiene geführt sind, um das Potential der außenliegenden Schiene 30 auf die der Kondensatorbatterie 24 zugeordnete Seite der Kondensatorplatine 22 zu bringen.

An den Stirnseiten der Stromschienen 14, 14' und 14" sind Anschlußklemmen 34, 34' und 34" angeordnet, an denen die umgeformte Wechselspannung abgenommen wird. Ein mehrpoliger Stecker 36 an der Frontseite des Gerätes dient der Verbindung nach draußen. Eine metallische Haube 38 bildet mit der Grundplatte 10 ein abgeschlossenes Gehäuse.

## Patentansprüche

1. Modular aufgebauter elektrischer Umformer mit einem Halbleiterventile bzw. Stromrichtermodule tragenden Stromschienensystem und einer mit den Halbleiterventilen bzw. den Stromrichtermodulen verbundenen Kondensatorbatterie die an eine Gleichspannung anschließbar ist sowie einer Ansteuerelektronik für die Halbleiterventile, und Anschließen für die Abnahme einer Ausgangs-Wechselspannung, **gekennzeichnet durch** drei parallel angeordnete T-förmige Stromschienen (14, 14', 14"), die mit ihrem Quersteg unter Zwischenfügung einer Isolierschicht (12, 12', 12") auf einer metallischen Grundplatte (10) befestigt sind, an ihren Längsstegen beidseits die Halbleiterventile (18) bzw. Stromrichtermodule tragen und mit den freien Enden der Längsstege eine Leistungsplatine (20) abstützen;
eine die Kondensatorbatterie (24) tragenden Platine (22) im Abstand parallel zur Leistungsplatine (20); und
eine Ansteuerelektronik (40), die an die Leistungsplatine (20) angeschlossen ist.

2. Umformer nach Anspruch 1, **dadurch gekennzeichnet**, daß die Leistungsplatine (20) mit ihrer Fläche die Kondensatorplatine (22) überragt und daß seitlich von der Kondensatorbatterie (24) die Ansteuerelektronik (40) auf der Leistungsplatine (20) angeordnet ist.

3. Umformer nach Anspruch 2, **dadurch gekennzeichnet**, daß die Kondensatoren der Kondensatorbatterie (24) aufrecht auf der Kondensatorplatine (22) angeordnet sind.

4. Umformer nach einem der Ansprüche 1 bis 3 zur Umformung einer Gleichspannung in eine drei-phasige Ausgangs-Wechselspannung, **dadurch gekennzeichnet**, daß an den Stirnseiten der drei T-förmigen Stromschienen (14, 14', 14") Anschlußklemmen (34, 34', 34") für die Abnahme der Wechselspannung angeordnet sind.

5. Umformer nach Anspruch 4, **gekennzeichnet durch** zwei Anschlußfahnen (26, 28) für die Zuführung der Gleichspannung an die Platinen (20, 22).

6. Umformer nach Anspruch 5, **gekennzeichnet durch** an die Anschlußfahnen (26, 28) angeschlossene Metallschienen (30, 32) zur Potentialführung, wobei eine Metallschiene (32) zwischen beiden Platinen (20, 22) angeordnet ist und beide Platinen im Abstand hält.

7. Umformer nach Anspruch 6, **dadurch gekennzeichnet**, daß beide Metallschienen (30, 32) durch die Leistungsplatine (20) getrennt übereinanderliegen und daß das Potential der außenliegenden Metallschiene (30) über eine Schraube (42) isolierend durch die beiden Platinen (20, 22) und die innenliegende Metallschiene (32) auf die Außenseite der Kondensatorplatine (22) geführt ist.

## Claims

1. A modular designed electrical converter comprising a current bus bar system supporting semiconductor valves or current rectifier modules and connectable to a DC voltage, respectively, and a condenser bank connected to the semiconductor valves or the current rectifier modules, respectively, as well as to a control electronics for the semiconductor valves and terminals for tapping an AC output voltage, **characterized by** three T-shaped current bus bars (14, 14', 14") arranged parallel with respect to each other, which are arranged with their cross bars on a metallic base plate (10) with an isolating layer (12, 12', 12") being arranged in between, which are supporting on both sides oftheir longitudinal ribs the semiconductor valves (18) or the current rectifier modules, respectively, and which are supporting with the free ends of the longitudinal ribs a power board (20);
a board (22) in a distance parallel to the power board (20) and supporting the condenser bank (24); and
a control electronics (40) connected to the power board (20).

2. Converter according to claim 1, **characterized in that** the power board (20) with its surface is extending beyond the condenser board (22) and that laterally to the condenser bank (24) the control electronics (40) is arranged on the power board (20).

3. Converter according to claim 2, **characterized in that** the condensers of the condenser bank (24) are arranged upright on the condenser board (22).

4. Converter according to one of claims 1 to 3 for converting a DC voltage into a three-phase AC output voltage, **characterized in that** at the pont sides of the three T-shaped current bus bars (14, 14', 14") connecting terminals (34, 34', 34") are provided for tapping the AC voltage.

5. Converter according to claim 4, **characterized by** two connecting lugs (26, 28) for feeding of the DC voltage to the boards (20, 22).

6. Converter according to claim 5, **characterized by** metal bars (30, 32) connected to the connecting lugs (26, 28) for supplying the potential, whereat one metal bar (32) is arranged between both boards (20, 22) and is spacing both boards.

7. Converter according to claim 6, **characterized in that** both metal bars (30, 32) are superimposed and separated by the power board (20) and that the potential of the external metal bar (30) is insulatorily guided to the outer surface ofthe condenser board (22) via a screw (42) through both boards (20, 22) and the inside metal bar (32).

## Revendications

1. Convertisseur électrique de structure modulaire comprenant un système de rails conducteurs portant des soupapes à semi-conducteur ou des modules convertisseurs de courant, et une batterie de condensateurs qui est reliée aux soupapes à semi-conducteur ou aux modules convertisseurs de courant et qui peut être branchée à une tension d'extinction, ainsi qu'une électronique de commande pour les soupapes à semi-conducteurs et des bornes pour prélever une tension alternative de sortie, caractérisé par trois rails conducteurs parallèles (14, 14', 14") en forme de T, qui sont fixés par leur branche transversale sur une plaque de base métallique (10), avec interposition d'une couche d'isolation (12, 12', 12"), portent des deux côtés sur leurs branches longitudinales les soupapes à semi-conducteurs (18) ou les modules convertisseurs de courant et supportent une platine de puissance (20) par les extrémités libres des branches longitudinales;
une platine (22) portant la batterie de condensateurs (24) montée parallèlement à la platine de puissance (20) et à distance de celle-ci, et
une électronique de commande (40) qui est raccordée à la platine de puissance (20).

2. Convertisseur selon la revendication 1, caractérisé en ce que la platine de puissance (20) dépasse par sa surface de la platine de condensateurs (22), et en ce que l'électronique de commande (40) est disposée latéralement à la batterie de condensateurs (24) sur la platine de puissance (20).

3. Convertisseur selon la revendication 2, caractérisé en ce que les condensateurs de la batterie de condensateurs (24) sont montés à la verticale sur la platine de condensateurs (22).

4. Convertisseur selon l'une des revendications 1 à 3, pour la conversion d'une tension continue en une tension de sortie alternative triphasée, caractérisé en ce que des bornes de raccordement (34, 34', 34") pour le prélèvement de la tension alternative sont disposées sur les faces frontales des trois rails conducteurs (14, 14', 14") en forme de T.

5. Convertisseur selon la revendication 4, caractérisé par deux barrettes de raccordement (26, 28) pour l'amenée de la tension continue aux platines (20, 22).

6. Convertisseur selon la revendication 5, caractérisé par des rails métalliques (30, 32) raccordés aux barrettes de raccordement (26, 28) pour l'amenée du potentiel, un rail métallique (32) étant disposé entre les deux platines (20, 22) et maintient les deux platines écartées l'une de l'autre.

7. Convertisseur selon la revendication 6, caractérisé en ce que les deux rails métalliques (30, 32) sont placés l'un au-dessus de l'autre en étant séparés par la platine de puissance (20), et en ce que le potentiel du rail métallique situé à l'extérieur (30) est amené par une vis (42) montée isolante à travers les deux platines (20, 22) et le rail métallique situé à l'intérieur (32), sur le côté extérieur de la platine de condensateurs (22).
